# EUROPÄISCHE PATENTSCHRIFT

(11) **EP 3 208 579 B1**
(45) Veröffentlichungstag und Bekanntmachung des Hinweises auf die Patenterteilung: **29.01.2020**
(21) Anmeldenummer: 16156684.9
(22) Anmeldetag: 22.02.2016
(51) Int. Cl.: G01F 23/284, G01S 13/88, G01S 7/35, G01S 13/34

(54) **REDUZIERUNG VON LEISTUNGSSPITZEN IM SPEKTRUM DER MITTLEREN LEISTUNG VON FÜLLSTANDMESSGERÄTEN**
REDUCTION OF POWER SPIKES IN THE AVERAGE POWER RANGE OF FILL LEVEL MEASURING DEVICES
REDUCTION DE POINTES DE PUISSANCE DANS LE SPECTRE DE LA PUISSANCE MOYENNE D'APPAREILS DE MESURE DE REMPLISSAGE

(43) Veröffentlichungstag der Anmeldung: 23.08.2017
(73) Patentinhaber: VEGA Grieshaber KG, 77709 Wolfach (DE)
(72) Erfinder: MÜLLER, Christoph, 77728 Oppenau (DE); FISCHER, Michael, 72275 Alpirsbach (DE)
(74) Vertreter: Maiwald Patent- und Rechtsanwaltsgesellschaft mbH

(56) Entgegenhaltungen:
- EP-A2- 2 631 612
- DE-A1-102009 013 300
- US-A1- 2014 253 147
- US-B1- 7 586 435

## Beschreibung

### Gebiet der Erfindung

Die Erfindung betrifft die Füllstandmessung. Insbesondere betrifft die Erfindung ein Verfahren zur Reduzierung von Leistungsspitzen im Frequenzspektrum der mittleren Leistung des Sendesignals von Füllstandmessgeräten, ein Füllstandradar, ein Programmelement sowie ein computerlesbares Medium.

### Hintergrund

Bei der Bestimmung des Füllstandes eines Füllgutes in einem Behälter oder auch außerhalb geschlossener Behälter (Freifeld) können Füllstandmessgeräte zum Einsatz kommen, die Radar- oder Ultraschallsignale in Richtung des Füllgutes aussenden und das an dem Füllgut reflektierte Signal registrieren, um aus diesem einen Füllstand zu ermitteln.

In den Spektren der über der Zeit gemittelten Leistung von Füllstandmessgeräten (auch RMS-Spektrum (RMS= Root Mean Square) genannt), welche zur Füllstandmessung als Sendesignal bzw. Messsignal beispielsweise Radarwellen in Form von frequenzmodulierten Dauerstrichsignalen, d.h. FMCW-Signalen (frequency modulated continuous wave, FMCW) aussenden, können bei bestimmten Frequenzen des Sendesignals Leistungsspitzen auftreten.

Diese Leistungsspitzen können durch ein Verharren des Sendesignals auf einer bestimmten Frequenz entstehen.

Insbesondere in dem Fall, in dem Radarwellen bei der Füllstandmessung zum Einsatz kommen, existieren gesetzliche Vorgaben bezüglich eines maximalen mittleren Leistungspegels des ausgestrahlten Signals. Um zulässige Sendepegel, für die beispielsweise in der EU harmonisierte Normen gelten, nicht zu überschreiten, kann der Sendepegel generell entsprechend niedrig gehalten werden. Eine andere Möglichkeit zulässige Grenzwerte für die mittlere Leistung eines Sendepegels nicht zu überschreiten besteht darin, die Radarsignale getaktet auszusenden. In diesem Fall wird innerhalb einer aktiven Periode ein Radarsignal durch das Füllstandmessgerät ausgesendet. Daran schließt sich eine inaktive Periode an, innerhalb derer das Füllstandmessgerät bzw. das für die Erzeugung bzw. Aussendung des Radarsignals verantwortliche Radarsystem des Füllstandmessgerätes abgeschaltet ist. Dadurch kann die mittlere Leistung des ausgesendeten Signals wirksam verringert werden. Die Spitzenleistung (peak power) des Sendesignals kann dadurch allerdings nicht beeinflusst werden.

US 7 586 435 B1 beschreibt ein FMCW Füllstandradargerät, das eine Frequenzrampe mit Abschnitten unterschiedlicher Steigung durchfährt.

EP 2 631 612 A2 beschreibt ein Radarfüllstandmessgerät, das zunächst ein Signal konstanter Frequenz abstrahlt und dann eine Frequenzrampe durchfährt.

### Zusammenfassung der Erfindung

Es ist eine Aufgabe der Erfindung, ein Verfahren zur Reduzierung von Leistungsspitzen bzw. Pegelerhöhungen im Spektrum der mittleren Leistung von Füllstandmessgeräten anzugeben, sowie ein Füllstandmessgerät mit einem bezüglich der zulässigen maximalen Sendepegel verbesserten Leistungsspektrum.

Es sind ein Füllstandmessgerät zur Bestimmung eines Füllstandes eines Füllgutes in einem Behälter unter Verwendung eines frequenzmodulierten Dauerstrichsignals (FMCW), ein Verfahren zum Betreiben eines Füllstandmessgerätes unter Verwendung eines frequenzmodulierten Dauerstrichsignals, ein Programmelement, sowie ein computerlesbares Medium gemäß den Merkmalen der unabhängigen Ansprüche angegeben. Weiterbildungen der Erfindung ergeben sich aus den Unteransprüchen.

Gemäß einem Aspekt der Erfindung ist ein Füllstandmessgerät zur Bestimmung eines Füllstandes eines Füllgutes in einem Behälter angegeben. Das Füllstandmessgerät kann auch zur Vermessung eines Massenstromes von Schüttgut auf beispielsweise einem Förderband zum Einsatz kommen. Das Füllstandmessgerät kann unter Verwendung eines frequenzmodulierten Dauerstrichsignals arbeiten. Dabei weist das Füllstandmessgerät zumindest die folgenden Komponenten auf. Eine Hochfrequenzschaltung, mittels derer ein Sendesignal erzeugt werden kann, wobei das Sendesignal mindestens eine Frequenzrampe aufweist; weiterhin eine Sendevorrichtung zum gerichteten Aussenden des Sendesignals in Richtung des Füllgutes, sowie eine Auswerteeinheit zur Bestimmung des Füllstandes des Füllgutes auf Basis eines am Füllgut reflektierten Sendesignals. Dabei weist die Frequenzrampe des Sendesignals eine minimale Frequenz fₘᵢₙ und eine maximale Frequenz von fₘₐₓ auf. Die Auswerteeinheit ist dazu ausgeführt, bei der Bestimmung des Füllstandes ausschließlich denjenigen Teil des am Füllgut reflektierten Sendesignals zu nutzen, dessen Frequenzen innerhalb eines Nutzfrequenzintervalls liegen. Dabei ist die minimale Frequenz des Nutzfrequenzintervalls größer als die minimale Frequenz fₘᵢₙ der Frequenzrampe und/oder die maximale Frequenz des Nutzfrequenzintervalls ist kleiner als die maximale Frequenz fₘₐₓ der Frequenzrampe.

Unter einer Frequenzrampe ist ein Sendesignal oder ein Teil eines Sendesignals zu verstehen, bei dem oder innerhalb dessen die Frequenz mit der Zeit monoton ansteigt oder monoton fällt. Auch eine Kombination aus monoton steigend und monoton fallend ist möglich.

Das Sendesignal des Füllstandmessgeräts kann beispielsweise über eine bestimmte Zeitdauer einen Anteil konstanter Frequenz aufweisen, an den sich eine Frequenzrampe anschließt, d.h. ein Anteil des Sendesignals, innerhalb dessen die Frequenz monoton mit der Zeit anwächst oder abfällt. Auch kann ein Sendesignal durch eine oder mehrere zeitlich aneinandergereihte bzw. aufeinander folgende Frequenzrampen gegeben sein, ohne dass eine Zeitdauer existieren muss, während derer das Signal bei einer konstanten Frequenz verharrt. Weiterhin ist es möglich, dass das Sendesignal nach dem Durchlaufen einer Frequenzrampe während einer anschließenden Zeitdauer bei einer konstanten Frequenz verharrt. Diese Frequenz kann beispielsweise durch die maximale Frequenz der Frequenzrampe gegeben sein. Auch sind weitere Kombinationen der vorbeschriebenen Zeitabhängigkeit der Frequenz des Sendesignals möglich.

Unter einem Nutzfrequenzintervall gemäß der Erfindung ist ein Frequenzintervall zu verstehen, innerhalb dessen diejenigen Frequenzen liegen, die bei der Bestimmung eines Füllstandes durch das Füllstandmessgerät berücksichtigt werden. D.h. die Auswertung eines an einem Füllgut reflektierten Sendesignals des Füllstandmessgeräts erfolgt nur mit Frequenzanteilen des reflektierten Sendesignals, die innerhalb des Nutzfrequenzintervalls liegen.

Die Unterscheidung zwischen einem Nutzfrequenzintervall und einem Frequenzbereich zwischen der minimalen Frequenz fₘᵢₙ und der maximalen Frequenz fₘₐₓ einer Frequenzrampe eines Sendesignals hat den folgenden Effekt: Ein mit einem frequenzmodulierten Dauerstrichsignal arbeitendes Füllstandmessgerät weist Schaltungsteile auf, die eine bestimmte Einschwing- bzw. Einlaufzeit aufweisen können. Sendesignale, die während der Dauer der Einschwing- bzw. Einlaufzeit dieser Schaltungsteile ausgesandt werden, können nicht für eine verlässliche Messung, d.h. für eine verlässliche Füllstandbestimmung herangezogen werden. Ein zur Messung herangezogener Anteil eines Sendesignals kann vorteilhafterweise durch eine Frequenzrampe gegeben sein, d.h. Signalanteile, bei denen über eine bestimmte Zeitdauer ein Sendesignalanteil mit konstanter Frequenz ausgesandt wird, können bei einer Messung unerwünscht sein. Aufgrund notwendiger Einschwing- bzw. Einlaufzeiten kann es möglicherweise nicht sinnvoll sein, direkt mit einer Frequenzrampe zu beginnen. Aus diesem Grund kann zunächst bei konstanter Frequenz die Einschwing- bzw. Einlaufzeit abgewartet werden, bevor der daran anschließende Teil des Sendesignals durch eine Frequenzrampe gegeben ist. Die vorliegende Erfindung umgeht das Aussenden eines Sendesignalanteils konstanter Frequenz während der Einschwing- bzw. Einlaufzeitdauer, indem bereits während dieser Zeitdauer ein Teil der Frequenzrampe durchlaufen wird, der allerdings nicht zur eigentlichen Messung herangezogen wird. Auf diese Weise können Zeiten, innerhalb derer ein Sendesignalanteil konstanter Frequenz ausgesandt wird, gänzlich entfallen oder zumindest deutlich reduziert werden.

Gemäß einem Ausführungsbeispiel der Erfindung ist die minimale Frequenz des Nutzfrequenzintervalls größer als die minimale Frequenz fₘᵢₙ der Frequenzrampe. Die Hochfrequenzschaltung ist in diesem Fall dazu ausgeführt, ausschließlich mindestens eine Frequenzrampe zu erzeugen, sodass das Sendesignal kein Dauerstrichsignal mit konstanter Frequenz aufweist. Die hier beschriebene Vorgehensweise kann in einem Leistungsspektrum gänzlich ohne Spitzen resultieren.

Das Sendesignal kann gemäß diesem Ausführungsbeispiel aus einer Vielzahl von Frequenzrampen bestehen, es besteht aber in jedem Fall aus mindestens einer Frequenzrampe. Wird eine Vielzahl von Frequenzrampen verwendet, so wächst die Frequenz des Sendesignals mit der Zeit in monotoner Weise von beispielsweise einer minimalen bis zu einer maximalen Frequenz an und springt daraufhin wieder zu der minimalen Frequenz, um, wie zuvor, von der minimalen bis zur maximalen Frequenz in monotoner Weise mit der Zeit anzusteigen. Damit weist das Sendesignal also kein Dauerstrichsignal mit konstanter Frequenz auf. Unter einem Dauerstrichsignal mit konstanter Frequenz ist dabei ein Signal zu verstehen, dessen Frequenz über einen Zeitraum konstant ist, der im Allgemeinen viel kleiner als das Zeitintervall ist, innerhalb dessen die Frequenzrampe durchlaufen wird. Beispielsweise kann der Zeitraum bzw. die Zeitdauer, während der ein konstantes Dauerstrichsignal abgestrahlt wird, durch die Einschwing- bzw. Einlaufzeit von Schaltungsteilen des Füllstandmessgeräts gegeben sein. Gemäß einem weiteren Ausführungsbeispiel der Erfindung weist das Sendesignal vor der Frequenzrampe ein Dauerstrichsignal mit konstanter Frequenz fsₘᵢₙ auf. Die minimale Frequenz fₘᵢₙ der Frequenzrampe stimmt dabei mit der Frequenz fsₘᵢₙ überein. Die Zeitdauer, während der ein Dauerstrichsignal konstanter Frequenz abgestrahlt wird, kann dabei kleiner als die Einschwing- bzw. Einlaufzeit von Schaltungsteilen des Füllstandmessgeräts sein.

Dies bedeutet mit anderen Worten, dass das Sendesignal in diesem Ausführungsbeispiel zunächst einen konstanten Beitrag bei fester Frequenz f_{Smin} aufweist, um darauffolgend eine Frequenzrampe, beginnend bei der Frequenz fₘᵢₙ bis zu einer maximalen Frequenz fₘₐₓ der Frequenzrampe zu durchlaufen. Da die minimale Frequenz fₘᵢₙ der Frequenzrampe mit der Frequenz f_{Smin} übereinstimmt, ist der Übergang von dem konstanten Dauerstrichsignal zur Frequenzrampe stetig. Die Zeitdauer innerhalb derer ein Dauerstrichsignal konstanter Frequenz ausgesandt wird, kann allerdings kleiner, bzw. insbesondere deutlich kleiner als die Einschwing- bzw. Einlaufzeit von Schaltungsteilen des Füllstandmessgeräts sein. Dies bedeutet, dass Schaltungsteile des Füllstandmessgerätes noch am Einschwingen bzw. Einlaufen sind, während die Frequenzrampe bereits gestartet wurde.

Gemäß einem weiteren Ausführungsbeispiel ist die Hochfrequenzschaltung des Füllstandmessgerätes dazu ausgeführt, die Frequenzrampe des Sendesignals mittels einer Phasenregelschleife (Phase locked loop, PLL) zu erzeugen. Integrierte PLL-Bausteine mit eingebautem Rampengenerator bieten diese Möglichkeit ohne zusätzlichen Schaltungsaufwand. Dabei wird die Frequenz des Sendesignals nach jedem Taktsignal, welches am PLL-Baustein anliegt, um einen vordefinierten Wert erhöht. Die minimale Frequenz des Nutzfrequenzintervalls wird erst nach einer festgelegten Anzahl von Taktsignalen erreicht.

Dies bedeutet, dass das Sendesignal einen Anteil von Frequenzen aufweist, die sich außerhalb des Nutzfrequenzintervalls befinden. Diese außerhalb des Nutzfrequenzintervalls befindlichen Frequenzen werden nicht in einer Auswertung eines am Füllgut reflektierten Sendesignals berücksichtigt.

Gemäß einem weiteren Ausführungsbeispiel ist die Hochfrequenzschaltung dazu ausgeführt, die Frequenzrampe des Sendesignals in einer Phasenregelschleife mittels regelmäßig aufeinanderfolgender Taktsignale an einem PLL-Baustein zu erzeugen, und im Zuge dessen die Frequenz des Sendesignals nach jedem Taktsignal um einen vordefinierten Wert zu erhöhen. Die maximale Frequenz des Sendesignals wird in diesem Fall erst nach einer festgelegten Anzahl von Taktsignalen erreicht und übersteigt die maximale Frequenz des Nutzfrequenzintervalls. Damit ist die maximale Sendefrequenz in diesem Fall größer als die maximale Frequenz des Nutzfrequenzintervalls.

Gemäß einem Ausführungsbeispiel der Erfindung kann das Nutzfrequenzintervall im Bereich zwischen 24 und 26,5 GHz liegen. Das Nutzfrequenzintervall kann auch zwischen 75 und 85 GHz liegen. Weiterhin kann vorgesehen sein, dass die Differenz zwischen der minimalen Frequenz des Nutzfrequenzintervalls und der minimalen Frequenz fₘᵢₙ der Frequenzrampe des Sendesignals größer ist als 100 MHz oder größer als 5% oder 10% des Nutzfrequenzintervalls und/oder die Differenz zwischen der maximalen Frequenz fₘₐₓ der Frequenzrampe und der maximalen Frequenz des Nutzfrequenzintervalls größer ist als 100 MHz. Es kann auch vorgesehen sein, dass zumindest eine der vorgenannten Differenzen größer als 10 MHz, größer als 50 MHz, oder größer als 200 MHz ist.

Die Frequenzdifferenz kann insbesondere von der Einschwingzeit der Phasenregelschleife bestimmt sein. Man kann also die Frequenz fₘᵢₙ der Frequenzrampe so wählen, dass spätestens beim Erreichen der minimalen Frequenz des Nutzfrequenzintervalls die Phasenregelschleife eingeschwungen und eingerastet (engl.: locked) ist.

In der Praxis bewegt sich diese Frequenzdifferenz dann tatsächlich im Bereich von beispielsweise 10MHz bis 200MHz.

Gemäß einem weiteren Aspekt der Erfindung ist ein Verfahren zum Betreiben eines Füllstandmessgerätes unter Verwendung eines frequenzmodulierten Dauerstrichsignals (FMCW) angegeben, wobei das Verfahren die nachfolgend genannten Schritte aufweist. Festlegen einer minimalen Frequenz fₘᵢₙ und einer maximalen Frequenz fₘₐₓ für mindestens eine Frequenzrampe eines Sendesignals. Weiterhin Festlegen eines Nutzfrequenzintervalls, wobei dieses Nutzfrequenzintervalls dadurch charakterisiert ist, dass die minimale Frequenz des Nutzfrequenzintervalls größer als die minimale Frequenz fₘᵢₙ der Frequenzrampe ist und/oder die maximale Frequenz des Nutzfrequenzintervalls kleiner als die maximale Frequenz fₘₐₓ der Frequenzrampe ist. In einem weiteren Verfahrensschritt wird das Sendesignal mit der mindestens einen Frequenzrampe erzeugt. In einem weiteren Verfahrensschritt erfolgt das Aussenden des Sendesignals in Richtung des Füllgutes. Schließlich kann das am Füllgut reflektierte Sendesignal unter Verwendung ausschließlich des Teils des reflektierten Sendesignals ausgewertet werden, der Frequenzen innerhalb des Nutzfrequenzintervalls aufweist.

Mit diesem Verfahren kann ein Verharren eines Anteils des Sendesignals während der Einschwing- bzw. Einlaufzeit von Schaltungsteilen des Füllstandmessgeräts vermieden oder zumindest signifikant reduziert werden. Beispielsweise kann die Zeitdauer, innerhalb derer ein Anteil des Sendesignals mit konstanter Frequenz ausgestrahlt wird um einen Faktor 4 gegenüber der Einschwing- bzw. Einlaufzeit reduziert werden. Auch ist eine Reduktion um einen Faktor 10 möglich. Weiterhin kann eine Zeitdauer während derer ein frequenzkonstantes Sendesignal ausgesandt wird, auch komplett entfallen. In den vorgenannten Fällen kann das Sendesignal während der Einschwing- bzw. Einlaufzeit bereits einen Teil einer Frequenzrampe durchlaufen. Nach Ablauf der Einschwingzeit wird dann entlang der Frequenzrampe eine minimale Frequenz des Nutzfrequenzintervalls erreicht. Ab dieser Frequenz werden die Sendesignalanteile zur Bestimmung des Füllstandes herangezogen.

Gemäß einem weiteren Aspekt der Erfindung ist ein Programmelement angegeben, das, wenn es auf einem Prozessor eines Füllstandmessgerätes ausgeführt wird, das Füllstandmessgerät dazu veranlasst, die im Zusammenhang des oben beschriebenen Verfahrens angegebenen Schritte auszuführen.

Gemäß einem weiteren Aspekt der Erfindung ist ein computerlesbares Medium angegeben, auf dem ein Programmelement mit den vorgenannten Eigenschaften gespeichert ist.

Im Folgenden werden, mit Verweis auf die Figuren, Ausführungsbeispiele der Erfindung beschrieben.

Kurze Beschreibung der Figuren
- Fig. 1a: zeigt ein Füllstandmessgerät mit einem Behälter, in dem sich ein Füllgut befindet.
- Fig. 1b: zeigt ein Blockschaltbild mit Komponenten eines Füllstandmessgerätes nach einem Ausführungsbeispiel der Erfindung.
- Fig. 2: zeigt die Frequenz eines Sendesignals eines Füllstandmessgerätes als Funktion der Zeit.
- Fig. 3: zeigt die Frequenz eines Sendesignals eines Füllstandmessgerätes mit Frequenzrampe als Funktion der Zeit gemäß einem Ausführungsbeispiel der Erfindung.
- Fig. 4a: zeigt die Abhängigkeit der Frequenz eines Sendesignals von der Zeit gemäß einem weiteren Ausführungsbeispiel der Erfindung.
- Fig. 4b: zeigt die Abhängigkeit der Frequenz eines Sendesignals von der Zeit gemäß einem weiteren Ausführungsbeispiel der Erfindung.
- Fig. 5: zeigt die Frequenzabhängigkeit des Spektrums der mittleren Leistung unterschiedlicher Sendesignale, die unter Verwendung eines frequenzmodulierten Dauerstrichsignals erzeugt wurden.
- Fig. 6: zeigt ein Flussdiagramm für ein Verfahren zum Betreiben eines Füllstandmessgerätes gemäß einem Ausführungsbeispiel der Erfindung.

Detaillierte Beschreibung von Ausführungsbeispielen

Unter Bezugnahme auf die Figuren werden im Folgenden Ausführungsbeispiele der Erfindung dargestellt. Merkmale und Eigenschaften, die im Zusammenhang mit einem Füllstandmessgerät beschrieben werden, können dabei ebenso auf das Verfahren übertragen werden, wie auch umgekehrt Schritte des Verfahrens in das Füllstandmessgerät bzw. dessen Betrieb implementiert werden können.

Die Darstellung in den Figuren ist schematisch und nicht maßstäblich. Werden in unterschiedlichen Figuren die gleichen Bezugszeichen verwendet, so bezeichnen diese gleiche oder ähnliche Elemente.

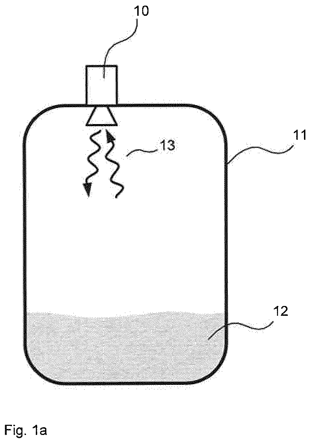

In Fig. 1a ist ein Füllstandmessgerät 10 gezeigt, das an einer oberen Behälterwand eines Behälters bzw. Containers 11 angebracht ist oder durch eine Öffnung der oberen Behälterwand zumindest teilweise in den Innenraum des Behälters eingebracht ist. Innerhalb des Behälters 11 befindet sich ein Füllgut 12. Zur Bestimmung des Füllstandes des Füllgutes 12 innerhalb des Behälters 11 kann das Füllstandmessgerät 10 Sendesignale 13 in Richtung des Füllgutes aussenden, welche an dem Füllgut reflektiert und anschließend durch das Füllstandmessgerät registriert und bei der Berechnung des Füllstandes verwendet werden. Bei den ausgesendeten Signalen kann es sich beispielsweise um Radarsignale handeln. Es ist jedoch auch möglich, dass Ultraschallsignale bei der Füllstandmessung zum Einsatz kommen.

Ein Sendesignal umfasst dabei einen bestimmten festgelegten Frequenzbereich. Dabei können gesetzliche Vorgaben, bzw. gesetzliche Normen existieren, die bestimmte Frequenzbänder festlegen, innerhalb derer die Frequenzen der Signale eines Füllstandmessgerätes liegen dürfen. Im Falle von Füllstandmessgeräten, die zur berührungslosen Füllstandmessung Radarsignale verwenden, liegen zulässige Sendefrequenzen beispielweise innerhalb des K-Bandes, d.h. zwischen 24,05 GHz und 26,5 GHz, oder innerhalb des W-Bandes, d.h. zwischen 75 GHz und 85 GHz. Es können weiterhin gesetzliche Vorgaben bezüglich eines maximalen mittleren Leistungspegels pro Frequenz innerhalb eines der gesetzlich zulässigen Frequenzbänder existieren. Durch Zeiten, innerhalb derer das Sendesignal eines Füllstandmessgerätes auf einer konstanten Frequenz verbleibt, resultieren entsprechende Erhöhungen des mittleren Leistungspegels bei dieser Frequenz.

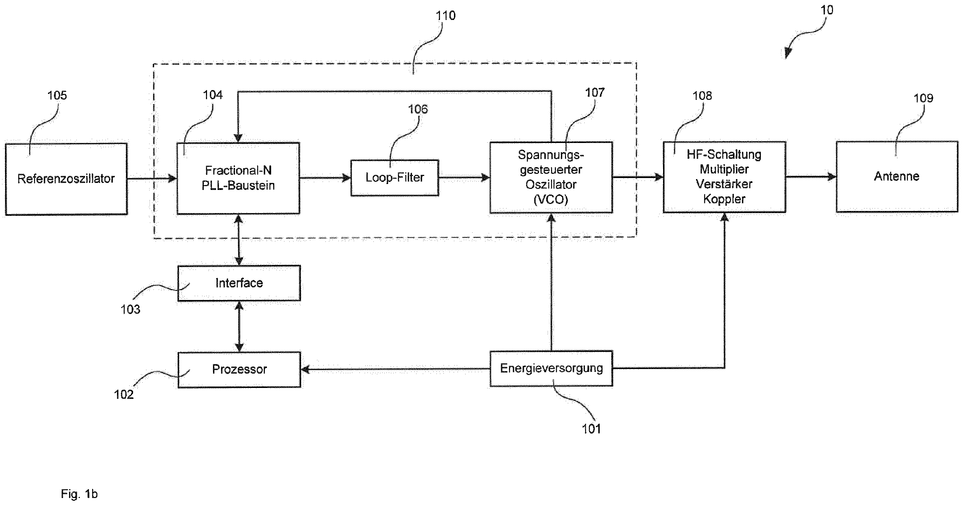

Ein Füllstandmessgerät kann beispielsweise eine durch das Blockschaltbild in Fig. 1b wiedergegebene Elektronik aufweisen. Die Elektronik des Füllstandmessgeräts 10 weist eine Energieversorgungseinheit, bzw. Energieversorgung 101 auf, die sowohl einen Prozessor 102, einen spannungsgesteuerten Oszillator (voltage controlled oscillator, VCO) 107 als auch einen HF-Schaltkreis 108 mit Energie versorgt. Der Prozessor 102 ist mit einem Interface 103 verbunden. In letzteres Interface 103 kann ein Nutzer beispielsweise den durch das Füllstandmessgerät zu verwendenden Frequenzbereich für Messungen eingeben. Auch die Eingabe weiterer Daten in das Interface, wie beispielsweise die Wiederhohlrate von Messungen, ist möglich. Diese eingegebenen Informationen können wiederum an den Prozessor 102 übergeben werden. Andererseits mit dem Interface 103 verbunden ist ein Fractional-N-Baustein 104. Dieser Fractional-N-Baustein 104 empfängt Signale eines Referenzoszillators 105 und gibt seinerseits Signale an ein Filter 106 weiter, das diese Signale wiederum dem spannungsgesteuerten Oszillator 107 zuführt. Der spannungsgesteuerte Oszillator 107 ist einerseits wiederum mit dem Fractional-N-Baustein 104 verbunden - entweder direkt oder über eine Teilerschaltung (Prescaler), sowie andererseits mit dem RF-Schaltkreis 108.

Die eigentliche Phasenregelschleife 110 ist durch die Bauteile Fractional-N PLL-Baustein 104, Loop-Filter 106 und den Spannungsgesteuerten Oszillator 107 ausgebildet. Die Regelschleife schließt sich mit dem Rückkopplungspfad von 107 nach 104.

Der RF-Schaltkreis 108 kann insbesondere aktive Schaltungen (Multiplier, Amplifier) sowie passive Elemente (Koppler, Zirkulatoren) und weitere Komponenten enthalten. Signale des RF-Schaltkreises werden auf den RF-Ausgang 109 gelegt und anschließend als Sendesignale des Füllstandmessgerätes 10 in Richtung des Füllguts ausgesandt. Die vorbeschriebenen Komponenten Fractional-N-Baustein104, Loopfilter 106, sowie spannungsgesteuerter Oszillator 107 können der Erzeugung eines frequenzmodulierten Dauerstrichsignals (FMCW-Signal) dienen.

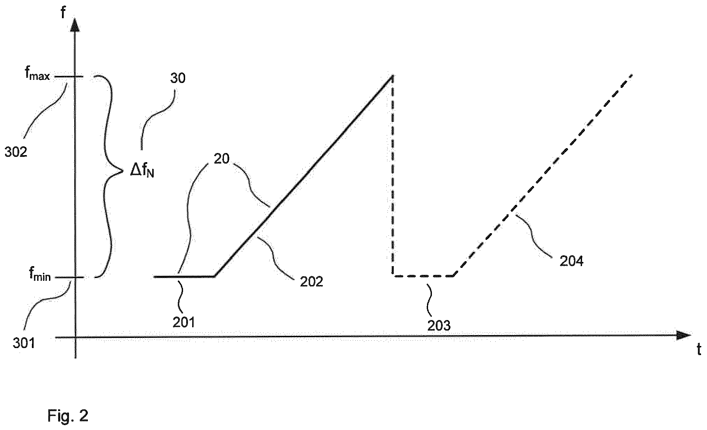

In Fig. 2 findet sich ein Beispiel für die Zeitabhängigkeit der Frequenz eines Sendesignals, eines frequenzmodulierten Dauerstrichsignals, eines Füllstandmessgerätes 10, wie es beispielsweise durch die Komponenten des in Fig. 1b dargestellten Blockschaltbildes erzeugt worden sein kann. Das Sendesignal 20 weist in Abhängigkeit der Zeit zunächst einen Frequenzkonstanten Beitrag 201 auf. Die Frequenz dieses konstanten Beitrages entspricht der minimalen Frequenz fₘᵢₙ des Sendesignals. Anschließend an die konstante Frequenz findet sich eine Frequenzrampe 202 des Sendesignals 20. Die Frequenzrampe ist durch einen monotonen Anstieg der Frequenz des Sendesignals in Abhängigkeit der Zeit von der minimalen Frequenz fₘᵢₙ bis hin zu einer maximalen Frequenz fₘₐₓ des Sendesignals charakterisiert. Es kann vorgesehen sein, dass die Sendeeinheit des Füllstandmessgerätes, nachdem die maximale Frequenz fₘₐₓ des Sendesignals erreicht ist, ausgeschaltet wird bzw. sich ausschaltet. Ist dies der Fall, besteht das Sendesignal 20 lediglich aus einem Signalanteil 201 konstanter Frequenz, an den sich eine Frequenzrampe 202 anschließt. Es ist aber auch möglich, dass ein Sendesignal 20 durch eine zeitliche Aneinanderreihung von Signalen des vorbeschriebenen Musters erhalten wird. In diesem Fall wird die Sendeeinheit des Füllstandmessgerätes nach Erreichen der maximalen Sendefrequenz fₘₐₓ nicht ausgeschaltet, sondern die Sendefrequenz wird wieder auf den minimalen Wert fₘᵢₙ gesetzt und es wird wiederum für eine begrenzte Zeit ein Signalanteil konstanter Frequenz ausgesandt. Dieser Signalanteil ist in Fig. 2 mit Bezugszeichen 203 bezeichnet. An diesen Abschnitt des Sendesignals schließt sich wiederum eine Frequenzrampe 204 an, innerhalb derer Frequenzen, mit der Zeit monoton anwachsend, von einer minimalen Frequenz fₘᵢₙ bis zu einer maximalen Frequenz fₘₐₓ durchlaufen werden.

In Fig. 2 ist das Nutzfrequenzintervall Δf_{N} 30 durch eine minimale Frequenz 301 und eine maximale Frequenz 302 gekennzeichnet. Im Falle der Fig. 2 fällt die minimale Frequenz des Nutzfrequenzintervalls 30 mit der minimalen Sendefrequenz fₘᵢₙ zusammen, und die maximale Frequenz 302 des Nutzfrequenzintervalls 30 stimmt mit der maximalen Sendefrequenz fₘₐₓ überein. Weiterhin ist in der Fig. 2 zu sehen, dass die Zeiten, innerhalb derer das Sendesignal bei der konstanten Frequenz fₘᵢₙ verharrt, von derselben Größenordnung sind, wie die Zeiten, innerhalb derer eine Frequenzrampe bei 202, 204 durchlaufen wird. Die Zeiten mit fester Frequenz können auch deutlich kürzer oder länger sein, als die Rampe.

Die frequenzstabilen Beiträge 201, 203 des Sendesignals 20 können sich daraus ergeben, dass der spannungsgesteuerte Oszillator zumindest zum Beginn eines Frequenzsweeps, und unter Umständen auch zum Ende eines Frequenzsweeps, stehen bleibt. Die Begriffe Frequenzsweep und Frequenzrampe können äquivalent verwendet werden.

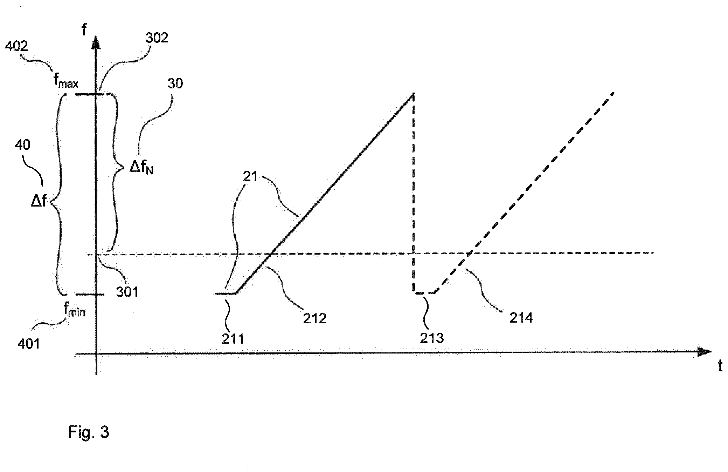

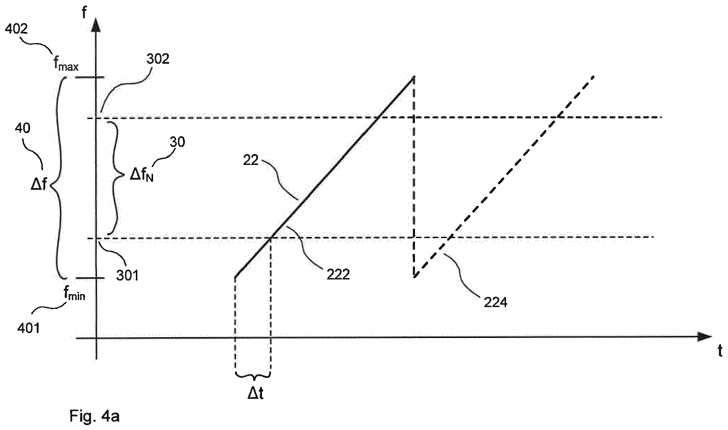

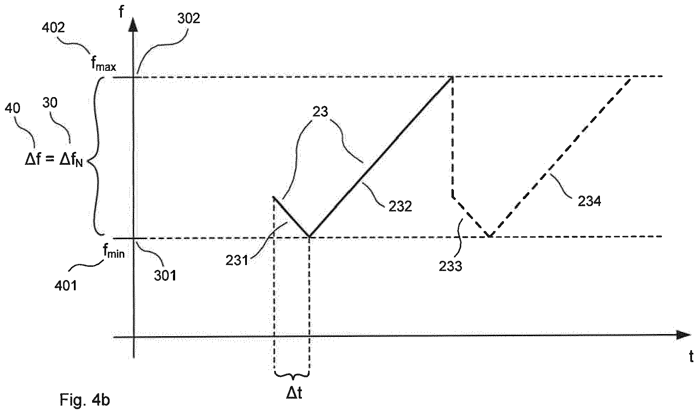

Solche "Standzeiten", während derer eine konstante Frequenz ausgesandt wird, sind typischerweise notwendig, um nachfolgende aktive Schaltungsteile, wie Multiplier, Amplifier, sowie weitere Komponenten, einzuschalten. Mit anderen Worten muss, wenn der Nutzfrequenzbereich 30, wie in Fig. 2 dargestellt, durch die minimale Sendefrequenz fₘᵢₙ und die maximale Sendefrequenz fₘₐₓ des Füllstandmessgerätes charakterisiert ist, vor dem Durchlaufen einer Frequenzrampe 202 zunächst eine Zeitdauer abgewartet werden, innerhalb derer entsprechende Elektronikkomponenten eingeschaltet werden und einschwingen können. Aus dem über eine bestimmte Zeitdauer konstanten Frequenzanteil bei beispielsweise der Frequenz fₘᵢₙ in Fig. 2 resultiert allerdings eine Erhöhung bei der Frequenz fₘᵢₙ im Spektrum der mittleren Leistung des Sendesignals. Um eine solche Erhöhung im Leistungsspektrum umgehen zu können, und maximal zulässige Grenzwerte nicht zu überschreiten, ohne den Sendepegel insgesamt über den gesamten Frequenzbereich des Sendesignals zu erniedrigen, schlägt die Erfindung beispielsweise die in Fig. 3 oder Fig. 4 gezeigten Frequenzabhängigkeiten des Sendesignals als Funktion der Zeit vor.

In Fig. 3 ist die Frequenz eines Sendesignals 21 eines Füllstandmessgerätes als Funktion der Zeit dargestellt. Das Messsignal 21 weist dabei eine minimale Frequenz fₘᵢₙ, 401, und eine maximale Frequenz fₘₐₓ, 402, auf. Das heißt, dass die Frequenzen des Sendesignals 21 innerhalb eines Sendefrequenzintervalls Δf, 40, liegen. Das Nutzfrequenzintervall bzw. der Nutzfrequenzbereich, 30, d.h. das Frequenzintervall Δf_{N} mit minimaler Frequenz 301 und maximaler Frequenz 302, liegt innerhalb des Sendefrequenzintervalls Δf 40. Nur diejenigen Sendefrequenzen innerhalb des Nutzfrequenzintervalls 30 sollen im Zuge der Füllstandbestimmung anhand eines an einem Füllgut reflektierten Sendesignals herangezogen werden. Das Sendesignal 21 weist einen Anteil 211 mit konstanter Frequenz, sowie einer Frequenzrampe 212 auf. Es ist möglich, dass das Sendesignal 21 lediglich aus den vorgenannten Anteilen 211, 212 besteht. Es ist aber auch möglich, dass das Sendesignal nach Erreichen des maximalen Sendefrequenzwertes fₘₐₓ 402, am Ende der Frequenzrampe 212 auf den minimalen Frequenzwert fₘᵢₙ, 401, des Sendesignals zurückspringt, und sich an die Frequenzrampe wiederum ein konstanter Frequenzanteil des Sendesignals, 213, bei der Frequenz fₘᵢₙ, 401, anschließt. An diesen frequenzkonstanten Anteil 213 kann sich wiederum eine Frequenzrampe 214 mit Frequenzen zwischen der minimalen Frequenz fₘᵢₙ und der maximalen Frequenz fₘₐₓ anschließen. Insbesondere kann das Sendesignal durch eine Vielzahl der vorbeschriebenen Sendesignalteile zusammengesetzt sein. Es ist aber auch möglich, dass das Sendesignal 21 lediglich aus einem frequenzkonstanten Beitrag 211 und einer daran anschließenden Frequenzrampe 212 besteht.

Im Vergleich zu dem in der Fig. 2 dargestellten Sendesignals 20 ist das in der Fig. 3 gezeigte Sendesignal 21 dadurch charakterisiert, dass der frequenzkonstante Beitrag bei der minimalen Sendefrequenz fₘᵢₙ, 401, innerhalb eines kürzeren Zeitintervalls ausgesandt wird. Aufgrund der kürzeren Zeitdauer, innerhalb derer ein Signal, beispielsweise ein Dauerstrichsignal mit konstanter Frequenz fₘᵢₙ ausgestrahlt wird, ist der mittlere Leistungspegel des Sendesignals 21 bei der minimalen Sendefrequenz fₘᵢₙ 401 geringer als der mittlere Leistungspegel des Sendesignals 20 bei der minimalen Sendefrequenz fₘᵢₙ 301 des Beispiels in Fig. 2. Allerdings kann die Zeitdauer, innerhalb derer das Sendesignal bei der minimalen Senderfrequenz fₘᵢₙ 401 verharrt, im Falle der Fig. 3 kleiner als die Einschwing- bzw. Einlaufzeit von Schaltungsteilen des Füllstandmessgerätes sein. Das bedeutet, dass Anteile des Sendesignals, die innerhalb der Einschwingzeit der Schaltungsteile des Füllstandmessgerätes ausgesandt werden, nicht zu Messzwecken herangezogen werden können, da sich erst nach Ablauf der Einschwingzeit verlässliche und zur Füllstandbestimmung verwendbare Sendesignalanteile ergeben. Dem Problem, dass Anteile der Frequenzrampe 212 in Fig. 3, die sich direkt an den frequenzkonstanten Anteil 211 des Sendesignals 21 anschließen, aufgrund der noch nicht abgelaufenen Einschwingzeit von Schaltungsteilen des Füllstandmessgerätes nicht zur Messung des Füllstandes heranzuziehen sind, wird dadurch begegnet, dass das Nutzfrequenzintervall 30 innerhalb dessen diejenigen Frequenzen liegen, die zur Füllstandmessung verwendet werden, eine minimale Frequenz 301 aufweist, die entlang der Frequenzrampe beispielsweise erst nach Ablauf der notwendigen Einschwing- bzw. Einlaufzeit erreicht wird.

Effektiv bedeutet dies, dass zunächst ein gewünschtes Nutzfrequenzintervall 30 ausgewählt bzw. vorgegeben sein kann. Des Weiteren kann die Einlauf- bzw. Einschwingzeit von Schaltungsteilen des Füllstandmessgerätes bekannt sein. Anstelle während der Einschwingzeit einen Sendesignalanteil konstanter Frequenz, an den sich eine Frequenzrampe anschließt, zur Füllstandmessung zu verwenden, besteht eine Idee der Erfindung darin, die Frequenzrampe zu kleineren Frequenzen, d.h. Frequenzen, die kleiner als die minimale Frequenz 301 des Nutzfrequenzintervalls sind, zu erweitern. Es sollen jedoch lediglich Frequenzen innerhalb des Nutzfrequenzintervalls 30 zur Füllstandmessung herangezogen werden. Auf diese Weise können Standzeiten, d.h. Zeiten, innerhalb derer das Sendesignal 21 durch einen konstanten Frequenzwert fₘᵢₙ 401 charakterisiert ist, reduziert werden. In vorteilhafter Weise wird dadurch der mittlere Leistungspegel bei der "Standfrequenz", d.h. bei dem über einen bestimmten Zeitraum konstanten Frequenzwert des Sendesignals, reduziert. Dadurch ist es also in vorteilhafter Weise möglich, die Einlauf- und Einschwingzeiten von Schaltungsteilen des Füllstandmessgerätes beizubehalten und die in diesen Zeiten vom Füllstandmessgerät abgestrahlte Leistung über einen durch die Frequenzrampe definierten größeren Frequenzbereich zu verteilen, anstelle die Leistung während der Einschwing- bzw. Einlaufzeit bei einer festen Frequenz, das heißt, beispielsweise der Start- oder auch der Endfrequenz der Frequenzrampe abzustrahlen.

Die oben und oder im Folgenden beschriebenen Frequenzrampen können in einem Radarsystem eines Füllstandmessgeräts, das ein frequenzmoduliertes Dauerstrichsignal erzeugen kann, beispielsweise in einer Phasenregelschleife mittels eines Taktsignals an einem Fractional-N-Baustein schrittweise erzeugt werden. In diesem Fall wird in jedem Taktzyklus die Ausgangsfrequenz des im Schaltbild nachgeschalteten spannungsgesteuerten Oszillators um eine bestimmte feste Größe erhöht. Auf diese Weise ist die jeweilige Ausgangsfrequenz in jedem Taktzyklus bekannt und genau definiert. Gemäß der Erfindung wird die Anfangsfrequenz des Sendesignals auf einen Wert gelegt, der niedriger als der minimale Wert des Nutzfrequenzintervalls ist. Eine entsprechende Frequenzrampe wird durch "hochtakten" der Phasenregelschleife erzeugt, bis mindestens die festgelegte maximale Frequenz des Nutzfrequenzintervalls erreicht ist. Es ist jedoch auch möglich, dass eine maximale Sendefrequenz, die größer als die maximale Frequenz des Nutzfrequenzbereiches ist, festgelegt ist. Die minimale Frequenz des Nutzfrequenzbereiches 30 wird nach Beginn der Frequenzrampe erst nach einer definierten Anzahl von Schritten erreicht. Erst nach Erreichen der minimalen Frequenz des Nutzfrequenzbereiches beginnt der Frequenzbereich des Sendesignals, der für die Füllstandmessung verwendet wird. Auf diese Weise kann vermieden werden, dass das Füllstandmessgerät während der Einlauf- bzw. Einschwingzeiten von Schaltungsteilen des Füllstandmessgerätes auf einem konstanten Wert, der beispielsweise dem minimalen Wert der Frequenzrampe und dem minimalen Wert des Nutzfrequenzintervalls entsprechen könnte, verharrt.

Fig. 4a zeigt die Frequenzabhängigkeit des Sendesignals 22 als Funktion der Zeit gemäß einem weiteren Ausführungsbeispiel der Erfindung. Das Sendesignal 22 weist demgemäß Frequenzen innerhalb eines Frequenzintervalls Δf, 40, zwischen einer minimalen Frequenz fₘᵢₙ 401 und einer maximalen Frequenz fₘₐₓ 402 auf. Innerhalb dieses Sendefrequenzintervalls Δf 40 befindet sich das Nutzfrequenzintervall Δf_{N}, 30, mit einer minimalen Frequenz 301 und einer maximalen Frequenz 302 des Nutzfrequenzintervalls. Das Sendesignal 22 ist allein durch mindestens eine Frequenzrampe 222 gegeben. Es entfällt also im Vergleich zu den Fällen der Fig. 2 und 3 ein Anteil des Sendesignals mit konstanter Frequenz. Das Sendesignal 22 kann wiederum aus mehreren identischen, zeitlich aufeinanderfolgenden Frequenzrampen 222, 224 gegeben seien. Wie aus Fig. 4 ersichtlich, ist die minimale Frequenz fₘᵢₙ 401 des Sendesignals 22 kleiner als die minimale Frequenz 301 des Nutzfrequenzintervalls Δf_{N}, 30. Auch ist in diesem Ausführungsbeispiel die maximale Frequenz fₘₐₓ 402 des Sendesignals 22 größer als die maximale Frequenz 302 des Nutzfrequenzintervalls 30. Innerhalb eines Zeitintervalls Δt können sich die Frequenzen des Sendesignals entlang der Frequenzrampe von dem minimalen Wert fₘᵢₙ 401 des Sendesignals 22 bis zu dem minimalen Wert 301 des Nutzfrequenzintervalls erhöhen. Die Zeit Δt soll erfindungsgemäß mindestens der Einlauf- bzw. Einschwingzeit von Schaltungsteilen des Füllstandmessgerätes entsprechen. Die Frequenzabhängigkeit des Sendesignals in Abhängigkeit der Zeit kann damit beispielsweise einen sägezahnartigen Verlauf, wie in Fig. 4 gezeigt, annehmen. Dadurch, dass die minimale Frequenz des Nutzfrequenzintervalls erst nach der Zeitdauer Δt erreicht wird, kann weiterhin der Notwendigkeit von Einschwing- bzw. Einlaufzeiten von Schaltungsteilen des Füllstandmessgeräts Rechnung getragen werden, ohne einen erhöhten Pegel der mittleren Leistung bei einer "Standfrequenz" vor Durchlaufen der Frequenzrampe 222, 224 aufzuweisen.

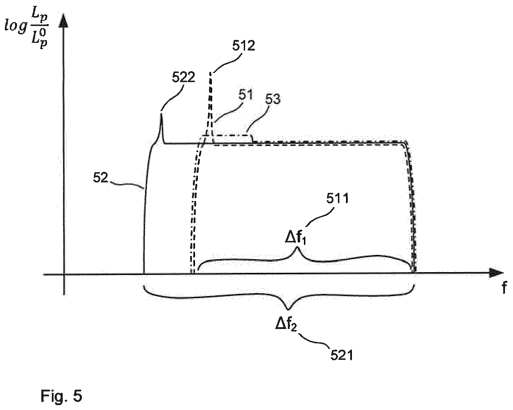

Auch kann während der Einlauf-/Einschwingzeit die Frequenzrampe innerhalb des Nutzfrequenzbandes starten und dann zuerst auf den Startwert der gewünschten Frequenzrampe (in der Frequenz nach unten) laufen, wie dies in Fig. 4b dargestellt ist. Der Frequenzbereich würde dadurch nicht über den Nutzfrequenzbereich hinaus aufgeweitet. Ein Teil des genutzten Frequenzspektrums würde allerdings zwei mal "durchfahren" - eine Pegelerhöhung um 3dB wäre das Ergebnis. Aber es entsteht keine "Nadel" bzw. Spitze 512 (vgl. Fig. 5).

Ein Vorteil im Vergleich zum Signalverlauf aus Figur 4a besteht darin, dass kein Frequenzspektrum "verschwendet" wird, d.h. Δf = Δf_{N}, Das Nutzfrequenzintervall 30 ist identisch mit dem Sendefrequenzintervall 40.

Fig. 5 zeigt eine logarithmische Darstellung des normierten und über der Zeit gemittelten Leistungsspektrums Lp 51, 52 von Sendesignalen als Funktion der Frequenz, wie sie beispielsweise ein Spektrumanalysator messen und darstellen kann. Dabei kann es sich bei dem logarithmierten Leistungsspektrum 51 beispielsweise um das Leistungsspektrum des in der Fig. 2 dargestellten Sendesignals 20 handeln. Das logarithmierte Leistungsspektrum 52 kann wiederum dem Leistungsspektrum des in der Fig. 3 dargestellten Sendesignals 21 entsprechen. Das Leistungspektrum 51 weist eine Leistungsspitze 512 bei der minimalen Frequenz des Frequenzintervalls Δf₁, 511, auf. Das Frequenzintervall Δf₁, 511, umfasst alle Frequenzen des dem Leistungsspektrum 51 zugrundeliegenden Sendesignals. Die Leistungsspitze 512 resultiert aus dem Anteil des zugrundeliegenden Sendesignals, bei dem das Sendesignal während eines bestimmten Zeitintervalls, beispielsweise der Einschwingzeit von Schaltungsteilen, auf einer konstanten Frequenz verharrt, bevor es die Frequenzrampe durchläuft.

Im Leistungsspektrum 52 findet sich ebenfalls eine Leistungsspitze 522, wobei selbige gegenüber der Leistungsspitze 512 des Leistungsspektrums 51 in der Größe deutlich reduziert ist. Das Leistungsspektrum 52 korrespondiert zu einem Sendesignal mit Sendefrequenzen innerhalb eines Frequenzintervalls Δf₂, 521, wobei sich die Leistungsspitze 522 im Leistungsspektrum bei der minimalen Frequenz des Frequenzintervalls Δf₂ 521 befindet. Auch diese Leistungsspitze 522 rührt von einem über ein begrenztes Zeitintervall konstanten Frequenzanteil des Sendesignals. Allerdings ist die Zeit innerhalb derer das korrespondierende Sendesignal einen konstanten Anteil aufweist, im Falle der Kurve 52 geringer als im Falle der Kurve 51. Daraus ergibt sich die Reduktion der Leistungsspitze 522 gegenüber der Leistungsspitze 512. Die Leistungsspitzen 512 bzw. 522 ausgenommen, sind die Leistungsspektren der mittleren Leistung 51 bzw. 52 jeweils innerhalb der Frequenzintervalle Δf₁, 511, bzw. Δf₂, 521, üblicherweise weitgehend konstant. Dies liegt daran, dass die durch ein entsprechendes Füllstandmessgerät abgestrahlte Energie im Falle der der Fig. 5 zugrunde liegenden Füllstandmessgeräte nahezu frequenzunabhängig ist und die beiden der gemittelten Leistungsspektren 51 bzw.52 zugrundeliegenden Frequenzrampen 202 bzw. 212 gleiche Steilheiten aufweisen. Durch die dargestellte Reduktion der Leistungsspitze im Spektrum der mittleren Leistung kann bei gleicher Energieabstrahlung durch das Füllstandmessgerät über einen vorgegebenen Messzeitraum das Problem von maximalen Leistungspegeln, die bei einer bestimmten Frequenz erreicht werden, umgangen werden. Insbesondere würde sich im Falle eines Sendesignals, wie es in Fig. 4b dargestellt ist, im Leistungsspektrum nach Fig. 5 keine Leistungsspitze im Leistungsspektrum mehr ergeben, sondern einen flachen, leicht erhöhten Verlauf 53.

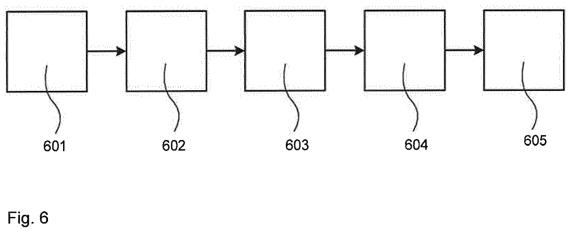

Fig. 6 zeigt ein Flussdiagramm eines Verfahrens zum Betreiben eines Füllstandmessgerätes unter Vermeidung bzw. Reduktion von Leistungsspitzen im Frequenzspektrum der mittleren Leistung des Füllstandmessgerätes. In einem Schritt 601 wird eine minimale Frequenz fₘᵢₙ und eine maximale Frequenz fₘₐₓ für mindestens eine Frequenzrampe des Sendesignals festgelegt. In einem Schritt 602 wird ein Nutzfrequenzintervall festgelegt, dessen minimale Frequenz größer als die minimale Frequenz der Frequenzrampe ist und/oder dessen maximale Frequenz kleiner als die maximale Frequenz fₘₐₓ der Frequenzrampe ist. Es ist auch möglich, dass der Schritt 602 der Festlegung des Nutzfrequenzintervalls, vor dem Schritt des Festlegens einer minimalen Frequenz fₘᵢₙ und einer maximalen Frequenz fₘₐₓ einer Frequenzrampe, 601, erfolgt. In einem nächsten Schritt 603 wird das Sendesignal mit mindestens einer Frequenzrampe durch das Füllstandmessgerät erzeugt, um in einem darauffolgenden Schritt 604 in Richtung eines Füllgutes ausgesandt zu werden. In Schritt 605 wird ein am Füllgut reflektiertes Sendesignal unter Verwendung ausschließlich desjenigen Teils des reflektierten Sendesignals ausgewertet, dessen Frequenzen innerhalb des in Schritt 602 festgelegten Nutzfrequenzintervalls liegen.

Ergänzend sei daraufhingewiesen, dass "umfassend" und "aufweisend" keine anderen Elemente oder Schritte ausschließt und die unbestimmten Artikel "eine" oder "ein" keine Vielzahl ausschließen. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Füllstandmessgerät (10) zur Bestimmung eines Füllstandes eines Füllgutes (12) in einem Behälter (11) unter Verwendung eines frequenzmodulierten Dauerstrichsignals, FMCW, das Füllstandmessgerät aufweisend:
eine Hochfrequenzschaltung zum Erzeugen eines Sendesignals (21, 22), wobei das Sendesignal mindestens eine Frequenzrampe (212, 222) aufweist;
eine Sendevorrichtung zum Aussenden des Sendesignals (21, 22) in Richtung des Füllgutes;
eine Auswerteeinheit zur Bestimmung des Füllstandes des Füllgutes auf Basis des am Füllgut reflektierten Sendesignals;
wobei die mindestens eine Frequenzrampe (212, 222) eine minimale Frequenz fₘᵢₙ und eine maximale Frequenz fₘₐₓ aufweist;
wobei die Auswerteeinheit dazu ausgeführt ist, bei der Bestimmung des Füllstandes ausschließlich den Teil des reflektierten Sendesignals mit Frequenzen innerhalb eines Nutzfrequenzintervalls (30) zu berücksichtigen;
wobei die minimale Frequenz (301) des Nutzfrequenzintervalls größer als die minimale Frequenz fₘᵢₙ der Frequenzrampe ist und/oder die maximale Frequenz (302) des Nutzfrequenzintervalls kleiner als die maximale Frequenz fₘₐₓ der Frequenzrampe ist;
**dadurch gekennzeichnet, dass** ein Teil der Frequenzrampe während einer Einschwingzeit von Schaltungsteilen des Füllstandmessgeräts durchlaufen wird und nach Ablauf der Einschwingzeit das Nutzfrequenzintervall erreicht ist.

2. Füllstandmessgerät nach Anspruch 1,
wobei die minimale Frequenz (301) des Nutzfrequenzintervalls (30) größer als die minimale Frequenz fₘᵢₙ der Frequenzrampe (212, 222) ist; CGS:CGS
wobei die Hochfrequenzschaltung dazu ausgeführt ist, ausschließlich mindestens eine Frequenzrampe (212, 222) zu erzeugen, so dass das Sendesignal (22) kein Dauerstrichsignal mit konstanter Frequenz (201, 203, 211, 213) aufweist.

3. Füllstandmessgerät nach Anspruch 1,
wobei das Sendesignal (21) vor der Frequenzrampe (212) ein Dauerstrichsignal (211) mit konstanter Frequenz f_{Smin} aufweist,
wobei die minimale Frequenz fₘᵢₙ der Frequenzrampe (212) mit der Frequenz f_{Smin} übereinstimmt.

4. Füllstandmessgerät nach einem der vorhergehenden Ansprüche,
wobei die Hochfrequenzschaltung dazu ausgeführt ist, die Frequenzrampe (212, 222) des Sendesignals (21, 22) mittels regelmäßig aufeinander folgender Taktsignale an einer Phasenregelschleife mit Rampengenerator zu erzeugen;
wobei die Hochfrequenzschaltung die Frequenz des Sendesignals (21, 22) nach jedem Taktsignal um einen vordefinierten Wert erhöht;
wobei die minimale Frequenz (301) des Nutzfrequenzintervalls (30) erst nach einer festgelegten Anzahl von Taktsignalen erreicht ist.

5. Füllstandmessgerät nach einem der vorhergehenden Ansprüche,
wobei die Hochfrequenzschaltung dazu ausgeführt ist, die Frequenzrampe (212, 222) des Sendesignals (21, 22) mittels regelmäßig aufeinander folgender Taktsignale an einer Phasenregelschleife zu erzeugen;
wobei die Hochfrequenzschaltung die Frequenz des Sendesignals (21, 22) nach jedem Taktsignal um einen vordefinierten Wert erhöht;
wobei die maximale Frequenz des Sendesignals (22) erst nach einer festgelegten Anzahl von Taktsignalen nach dem Erreichen der maximalen Frequenz (302) des Nutzfrequenzintervalls (30) erreicht ist.

6. Füllstandmessgerät nach einem der vorhergehenden Ansprüche,
wobei das Nutzfrequenzintervall (30) im Bereich zwischen 24,05 und 26,5 GHz oder zwischen 75 und 85 GHz liegt; und
wobei die Differenz zwischen der minimalen Frequenz (301) des Nutzfrequenzintervalls (30) und der minimalen Frequenz fₘᵢₙ der Frequenzrampe (212, 222) des Sendesignals (21, 22) größer ist als 100 MHz und/oder die Differenz zwischen der maximalen Frequenz fₘₐₓ der Frequenzrampe (212, 222) und der maximalen Frequenz (302) des Nutzfrequenzintervalls (30) größer ist als 100 MHz.

7. Verfahren zum Betreiben eines Füllstandmessgeräts (10) zur Bestimmung eines Füllstandes eines Füllgutes (12) in einem Behälter (11) unter Verwendung eines frequenzmodulierten Dauerstrichsignals, FMCW, das Verfahren aufweisend die Schritte:
Festlegen einer minimalen Frequenz fₘᵢₙ und einer maximalen Frequenz fₘₐₓ für mindestens eine Frequenzrampe (212, 222) eines Sendesignals (21, 22);
Festlegen eines Nutzfrequenzintervalls (30), wobei die minimale Frequenz (301) des Nutzfrequenzintervalls (30) größer als die minimale Frequenz fₘᵢₙ der Frequenzrampe ist und/oder die maximale Frequenz (302) des Nutzfrequenzintervalls (30) kleiner als die maximale Frequenz fₘₐₓ der Frequenzrampe ist (212, 222);
Erzeugen des Sendesignals (21, 22) mit der mindestens einen Frequenzrampe (212, 222);
Aussenden des Sendesignals (21, 22) in Richtung des Füllgutes;
Auswerten des am Füllgut reflektierten Sendesignals unter Verwendung ausschließlich des Teils des reflektierten Sendesignals mit Frequenzen innerhalb des Nutzfrequenzintervalls (30);
**dadurch gekennzeichnet, dass** ein Teil der Frequenzrampe während einer Einschwingzeit von Schaltungsteilen des Füllstandmessgeräts durchlaufen wird und nach Ablauf der Einschwingzeit das Nutzfrequenzintervall erreicht ist.

8. Programmelement, das, wenn es auf einem Prozessor eines Füllstandmessgeräts ausgeführt wird, das Füllstandmessgerät anleitet, die Schritte nach Anspruch 7 auszuführen.

9. Computerlesbares Medium, auf dem ein Programmelement nach Anspruch 8 gespeichert ist.

## Claims

1. A fill level measuring device (10) for determining a level of a filling material (12) in a vessel (11) using a frequency-modulated continuous wave, FMCW, signal, the fill level measuring device (10) comprising:
a high-frequency circuit configured to generate a transmission signal (21, 22), wherein the transmission signal has at least one frequency ramp (212, 222);
a transmission apparatus configured to emit the transmission signal (21, 22) towards the filling material (12);
an evaluation unit configured to determine the level of the filling material (12) on the basis of the transmission signal (21, 22) reflected at the filling material (12);
wherein the at least one frequency ramp (212, 222) has a minimal frequency fₘᵢₙ and a maximal frequency fₘₐₓ;
wherein, when determining the fill level, the evaluation unit is configured to consider only a part of the reflected transmission signal that has frequencies within a fundamental frequency interval (30),
wherein the minimal frequency (301) of the fundamental frequency interval (30) is greater than the minimal frequency fₘᵢₙ of the frequency ramp and/or the maximal frequency (302) of the fundamental frequency interval is smaller than the maximal frequency fₘₐₓ of the frequency ramp,
**characterized in that**
a part of the frequency ramp is passed during a settling time of parts of the fill level measuring device, and the fundamental frequency interval is reached after the settling time.

2. The fill level measuring device according to claim 1,
wherein the minimal frequency (301) of the fundamental frequency interval (30) is greater than the minimal frequency fₘᵢₙ of the frequency ramp (212, 222);
wherein the high-frequency circuit is configured to generate only at least one frequency ramp (212, 222), so that the transmission signal has no continuous wave signal having a constant frequency (201, 203, 211, 213).

3. The fill level measuring device according to claim 1,
wherein the transmission signal (21) before the frequency ramp (212) has a continuous wave signal (211) having a constant frequency f_{Smin},
wherein the minimal frequency fₘᵢₙ of the frequency ramp (212) coincides with the frequency f_{Smin}.

4. The fill level measuring device according to one of the preceding claims,
wherein the high-frequency circuit is configured to generate the frequency ramp (212, 222) of the transmission signal (21, 22) by means of regularly successing clock signals at a phase-locked loop with a ramp generator;
wherein the high-frequency circuit is configured to increase the frequency of the transmission signal (21, 22) by a predefined value after every clock signal;
wherein the minimal frequency (301) of the fundamental frequency interval (30) is reached only after a determined number of clock signals.

5. The fill level measuring device according to one of the preceding claims,
wherein the high-frequency circuit is configured to generate the frequency ramp (212, 222) of the transmission signal (21, 22) by means of regularly successing clock signals at a phase-locked loop;
wherein the high-frequency circuit is configured to increase the frequency of the transmission signal (21, 22) by a predefined value after every clock signal;
wherein the maximal frequency of the transmission signal (22) is reached only after a determined number of clock signals after the maximal frequency of the fundamental frequency interval (30) has been reached.

6. The fill level measuring device according to one of the preceding claims,
wherein the fundamental frequency interval (30) lies in the range between 24.05 and 26.5 GHz or between 75 and 85 GHz; and
wherein the difference between the minimal frequency (301) of the fundamental frequency interval (30) and the minimal frequency fₘᵢₙ of the frequency ramp (212, 222) of the transmission signal (21, 22) is greater than 100 MHz and/or the difference between the maximal frequency fₘₐₓ of the frequency ramp (212, 222) and the maximal frequency of the fundamental frequency interval (30) is greater than 100 MHz.

7. A method for operating a fill level measuring device (10) for determining a fill level of a filling material (12) in a vessel (11) using a frequency modulated continuous wave signal, FMCW, the method comprising the steps:
determining a minimal frequency fₘᵢₙ and a maximal frequency fₘₐₓ for at least one frequency ramp (212, 222) of a transmission signal (21, 22);
determining a fundamental frequency interval (30), wherein the minimal frequency (301) of the fundamental frequency interval (30) is greater than the minimal frequency fₘᵢₙ of the frequency ramp and/or the maximal frequency (302) of the fundamental frequency interval (30) is smaller than the maximal frequency fₘₐₓ of the frequency ramp (212, 222);
generating the transmission signal (21, 22) with the at least one frequency ramp (212, 222);
emitting the transmission signal (21, 22) towards the filling material (12);
evaluating the transmission signal reflected at the filling material (12) using only the part of the reflected transmission signal having frequencies within the fundamental frequency interval (30),
**characterized in that**
a part of the frequency ramp is passed during a settling time of parts of the fill level measuring device, and the fundamental frequency interval is reached after the settling time.

8. A program element which, when executed on a processor of a fill level measuring device, instructs the fill level measuring device to carry out the steps according to claim 7.

9. A computer-readable medium, on which a program element according to claim 8 is stored.

## Revendications

1. Appareil de mesure de remplissage (10) destiné à déterminer un niveau de remplissage d'un produit de remplissage (12) dans un récipient (11) en utilisant un signal à onde continue à fréquence modulée, FMCW, l'appareil de mesure de remplissage comprenant:
un circuit à haute fréquence pour générer un signal d'émission (21, 22), le signal d'émission comportant au moins une rampe de fréquence (212, 222);
un dispositif d'émission pour émettre le signal d'émission (21, 22) en direction du produit de remplissage;
une unité d'évaluation pour déterminer le niveau de remplissage du produit de remplissage sur la base du signal d'émission réfléchi sur le produit de remplissage;
l'au moins une rampe de fréquence (212, 222) présentant une fréquence minimale fₘᵢₙ et une fréquence maximale fₘₐₓ;
l'unité d'évaluation étant conçue pour prendre en compte uniquement la partie du signal d'émission réfléchi ayant des fréquences comprises dans un intervalle de fréquence utile (30) lors de la détermination du niveau de remplissage;
la fréquence minimale (301) de l'intervalle de fréquence utile étant supérieure à la fréquence minimale fₘᵢₙ de la rampe de fréquence et/ou la fréquence maximale (302) de l'intervalle de fréquence utile étant inférieure à la fréquence maximale fₘₐₓ de la rampe de fréquence;
**caractérisé en ce qu'**une partie de la rampe de fréquence se déroule pendant un durée d'établissement de parties de circuit de l'appareil de mesure de remplissage et l'intervalle de fréquence utile est atteint après la fin du durée d'établissement.

2. Appareil de mesure de remplissage selon la revendication 1, dans lequel la fréquence minimale (301) de l'intervalle de fréquence utile (30) est supérieure à la fréquence minimale fₘᵢₙ de la rampe de fréquence (212, 222);
dans lequel le circuit à haute fréquence est conçu pour générer exclusivement au moins une rampe de fréquence (212, 222), de telle sorte que le signal d'émission (22) ne présente pas de signal à onde continue avec une fréquence constante (201, 203, 211, 213).

3. Appareil de mesure de remplissage selon la revendication 1, dans lequel le signal d'émission (21) présente, avant la rampe de fréquence (212), un signal à onde continue (211) avec une fréquence constante f_{Smin},
dans lequel la fréquence minimale fₘᵢₙ de la rampe de fréquence (212) correspond à la fréquence f_{Smin}.

4. Appareil de mesure de remplissage selon l'une des revendications précédentes,
dans lequel le circuit à haute fréquence est conçu pour générer la rampe de fréquence (212, 222) du signal d'émission (21, 22) au moyen de signaux d'horloge successifs réguliers sur une boucle d'asservissement de phase avec générateur de rampe;
dans lequel le circuit à haute fréquence augmente la fréquence du signal d'émission (21, 22) d'une valeur prédéfinie après chaque signal d'horloge;
dans lequel la fréquence minimale (301) de l'intervalle de fréquence utile (30) est atteinte seulement après un nombre défini de signaux d'horloge.

5. Appareil de mesure de remplissage selon l'une des revendications précédentes,
dans lequel le circuit à haute fréquence est conçu pour générer la rampe de fréquence (212, 222) du signal d'émission (21, 22) au moyen de signaux d'horloge successifs réguliers sur une boucle d'asservissement de phase;
dans lequel le circuit à haute fréquence augmente la fréquence du signal d'émission (21, 22) d'une valeur prédéfinie après chaque signal d'horloge;
dans lequel la fréquence maximale du signal d'émission (22) est atteinte seulement après un nombre défini de signaux d'horloge après que la fréquence maximale (302) de l'intervalle de fréquence utile (30) a été atteinte.

6. Appareil de mesure de remplissage selon l'une des revendications précédentes,
dans lequel l'intervalle de fréquence utile (30) est compris entre 24,05 et 26,5 GHz ou entre 75 et 85 GHz; et
dans lequel la différence entre la fréquence minimale (301) de l'intervalle de fréquence utile (30) et la fréquence minimale fₘᵢₙ de la rampe de fréquence (212, 222) du signal d'émission (21, 22) est supérieure à 100 MHz et/ou la différence entre la fréquence maximale fₘₐₓ de la rampe de fréquence (212, 222) et la fréquence maximale (302) de l'intervalle de fréquence utile (30) est supérieure à 100 MHz.

7. Procédé de fonctionnement d'un appareil de mesure de remplissage (10) destiné à déterminer un niveau de remplissage d'un produit de remplissage (12) dans un récipient (11) en utilisant un signal à onde continue à fréquence modulée, FMCW, le procédé comprenant les étapes de:
définition d'une fréquence minimale fₘᵢₙ et d'une fréquence maximale fₘₐₓ pour au moins une rampe de fréquence (212, 222) d'un signal d'émission (21, 22);
définition d'un intervalle de fréquence utile (30), la fréquence minimale (301) de l'intervalle de fréquence utile (30) étant supérieure à la fréquence minimale fₘᵢₙ de la rampe de fréquence et/ou la fréquence maximale (302) de l'intervalle de fréquence utile (30) étant inférieure à la fréquence maximale fₘₐₓ de la rampe de fréquence (212, 222);
génération du signal d'émission (21, 22) avec l'au moins une rampe de fréquence (212, 222);
émission du signal d'émission (21, 22) en direction du produit de remplissage;
évaluation du signal d'émission réfléchi sur le produit de remplissage en utilisant uniquement la partie du signal d'émission réfléchi ayant des fréquences comprises dans l'intervalle de fréquence utile (30);
**caractérisé en ce qu'**une partie de la rampe de fréquence se déroule pendant un durée d'établissement de parties de circuit de l'appareil de mesure de remplissage et l'intervalle de fréquence utile est atteint après la fin du durée d'établissement.

8. Élément de programme qui, lorsqu'il est exécuté sur un processeur d'un appareil de mesure de remplissage, amène l'appareil de mesure de remplissage à exécuter les étapes selon la revendication 7.

9. Support lisible par ordinateur, sur lequel est enregistré un élément de programme selon la revendication 8.
